(19) Europäisches Patentamt
European Patent Office
Office européen des brevets

(11) **EP 4 614 803 B1**

(12) **EUROPEAN PATENT SPECIFICATION**

(45) Date of publication and mention
of the grant of the patent:
**01.07.2026 Bulletin 2026/27**

(21) Application number: **25157163.4**

(22) Date of filing: **11.02.2025**

(51) International Patent Classification (IPC):
*H02P 29/024* (2016.01)     *H02P 5/74* (2006.01)
*H02P 25/22* (2006.01)     *H02P 23/14* (2006.01)
*G01R 31/34* (2020.01)

(52) Cooperative Patent Classification (CPC):
**H02P 29/024; G01R 31/343; H02P 5/74;**
**H02P 23/14; H02P 25/22**

(54) **DETECTING ROTOR DEMAGNETIZATION**

ERKENNUNG DER ROTORDEMAGNETISIERUNG

DÉTECTION DE DÉMAGNÉTISATION DE ROTOR

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **05.03.2024 GB 202403154**

(43) Date of publication of application:
**10.09.2025 Bulletin 2025/37**

(73) Proprietor: **Rolls-Royce plc**
**London N1 9FX (GB)**

(72) Inventors:
• **Vaiyapuri, Viswanathan**
**Derby, DE24 8BJ (GB)**
• **Nadarajan, Sivakumar**
**Derby, DE24 8BJ (GB)**
• **Kumar, Logesh**
**Derby, DE24 8BJ (GB)**

(74) Representative: **Rolls-Royce plc**
**P.O. Box 31**
**IP Department (SinA-48)**
**Derby Derbyshire DE24 8BJ (GB)**

(56) References cited:
**US-A1- 2012 146 683     US-A1- 2022 282 635**

**Description**

**TECHNICAL FIELD**

The present disclosure concerns the detection of rotor magnet demagnetization in permanent magnet electrical machines.

**BACKGROUND**

Permanent magnet synchronous electrical machines (PMSMs) are increasingly used because of their attractive power density. A PMSM generally comprises a rotor that carries permanent magnets, and a stator that comprises a polyphase (e.g., three-phase) winding set. If operating as a motor, the polyphase winding set is energized by an electrical power source, often via an inverter with active power semiconductor switches, to create a rotating magnetic field which interacts with the rotor magnets to create a torque that rotates the rotor. If operating as a generator, the rotor is driven to rotate by a drive shaft (e.g., of a prime mover) and the rotating permanent magnets create a rotating magnetic field that induces a voltage in the stator windings.

A problem with PMSMs is that the permanent magnets may, over time, become partially or totally demagnetized. This may happen because of adverse operating conditions, for example high temperatures. Demagnetization of the rotor magnets results in variation in the air-gap magnetic flux density, which may in turn introduce harmonics in the voltage and current waveforms, losses, vibration, acoustic noise and even shaft trajectory displacement. It can also create eddy currents in the permanent magnets, which introduces further losses and can cause significant heating in the magnets, potentially causing further demagnetization.

Known techniques for detecting rotor demagnetization typically involve the use of complex time- or frequency-domain analysis of measured signals, and the use of threshold values that must be derived from large amounts of experimental or historical operating data. European Patent Publication EP 3876419 B1 derives flux linkage values from current and voltage measurements and compares the flux linkage values to a predefined threshold to detect rotor demagnetization.

US2022/282635A1 describes an electrical power systems for distributing electrical power in arrangements including one or more gas turbine engines; one such system includes: one or more rotary electric machines, coupled to a gas turbine engine spool; converter circuits connected to the rotary electric machines converting between alternating current (ac) and direct current (dc), wherein the rotary electric machines and the converter circuits output a number $R \geq 2$ of dc power channels, each channel having an index $r=(1, \dots , R)$; and a group of N dc load channels connected to the R dc power channels by a switching arrangement, wherein each dc load channel has an index $n=(1, \dots , N)$ and $R < N \leq 2R$.

US2012/146683A1 describes a system for monitoring failure within electrical machines. Under a condition that rotor rotation speeds wes are equal, winding wire currents Id, Iq are equal, and winding wire inductances Ld, Lq are equal in first and second electric motors (1, 2), a magnet temperature anomaly detector (30) provided in a microcomputer (5) calculates a change ratio $d(|\Phi ml-\Phi mr|)/dt$ of a magnetic flux difference between the first and second electric motors (1, 2) based on the difference $Vql^*-Vqr^*$ between a q-axis voltage command value $Vql^*$ corresponding to the first electric motor (1) and a q-axis voltage command value Vqr corresponding to the second electric motor (2), and then when the change ratio $d(|\Phi ml-\Phi mr|)/dt$ of the magnetic flux difference is more than a predetermined threshold Sh1, it is determined that a permanent magnet of at least any one of the electric motors (1, 2) has a temperature anomaly.

**SUMMARY**

The scope of the disclosure is set out in the appended claims. According to a first aspect there is an electrical power system comprising: first and second electrical machines, each comprising a permanent magnet rotor and a stator comprising a plurality of electrically isolated polyphase winding sets; and

a control and health monitoring system configured to detect rotor demagnetization of the first and/or second electrical machine by:

supplying electrical power to each polyphase winding set of the plurality of polyphase windings sets of the first electrical machine;
stopping the supply of electrical power to a first polyphase winding set of the first electrical machine;
measuring a first voltage across the first polyphase winding set of the first electrical machine;
supplying electrical power to each polyphase winding set of the plurality of polyphase windings sets of the second electrical machine;
stopping the supply of electrical power to a first polyphase winding set of the second electrical machine;
measuring a second voltage across the first polyphase winding set of the second electrical machine;

determining first and second magnetic flux linkage indicators based on the first and second voltages; and determining whether the permanent magnet rotor of the first and/or second electrical machine is demagnetized based on the whether a ratio of the first and second magnetic flux linkage indicators passes a threshold.

Optionally, stopping the supply of electrical power to the first polyphase winding set of the first electrical machine comprises opening a circuit breaker connected with the polyphase winding set of the first electrical machine.

Optionally, the electrical power system further comprises a plurality of DC:AC power converters. For each of the first and second electrical machines, each respective polyphase winding set of the plurality of polyphase winding sets is connected to and configured to receive electrical power from a respective one of the plurality of DC:AC power converters.

Optionally, stopping the supply of electrical power to the first polyphase winding set of the first electrical machine comprises controlling a switching operation of the respective one of the plurality of DC:AC converters to which the first polyphase winding set of the first electrical machine is connected to block current flow to the first polyphase winding set of the first electrical machine.

Optionally, supplying electrical power to each polyphase winding set of the plurality of polyphase windings sets of the first electrical machine comprises supplying less than 25% of a peak rated power of the first electrical machine; and supplying electrical power to each polyphase winding set of the plurality of polyphase windings sets of the first electrical machine comprises supplying less than 25% of a peak rated power of the second electrical machine.

According to the invention, supplying electrical power to each polyphase winding set of the plurality of polyphase windings sets of the first electrical machine comprises supplying electrical power to only one phase of a plurality of phases of each polyphase winding set of the first electrical machine, and supplying electrical power to each polyphase winding set of the plurality of polyphase windings sets of the second electrical machine comprises supplying electrical power to only one phase of a plurality of phases of each polyphase winding set of the second electrical machine.

Optionally, the electrical power system further comprises an energy storage system, e.g., one or more batteries. Electrical power is supplied to the polyphase winding sets of the first and second electrical machines from the energy storage system.

Optionally, the energy storage system comprises a plurality of electrically isolated energy storage sub-systems. Each polyphase winding set of the plurality of polyphase winding sets of the first and second electrical machine is configured to receive electrical power from a respective one of the plurality of electrically isolated energy storage sub-systems.

Optionally, the first and second electrical machines have an equal number of polyphase winding sets.

Optionally, the number of polyphase winding sets is two or four.

Optionally, for each of the first and second electrical machines, a circumference of the stator is divided into a plurality of sectors, and each polyphase winding set of the plurality of polyphase winding sets occupies one of the plurality of sectors.

Optionally, the first and second electrical machines are transverse flux electrical machines.

Optionally, each polyphase winding set is a three-phase winding set.

The control and health monitoring system may take any suitable form. Optionally, the control and health monitoring system comprises one or more controllers, for example one or more DC:AC converter controllers. The control and health monitoring system may take any suitable form may be configured to perform a rotor demagnetization detection test as a pre-start check.

According to a second aspect, there is an aircraft comprising the electrical power system of the first aspect.

Optionally, the aircraft comprises a first electrical propulsion unit (EPU) comprising a propeller or fan configured to be driven to rotate by the permanent magnet rotor of the first electrical machine; and a second EPU comprising a propeller or fan configured to be driven to rotate by the permanent magnet rotor of the second electrical machine.

According to a third aspect, there is a method of detecting rotor demagnetization in a permanent magnet electrical machine of an electrical power system, the electrical power system comprising first and second electrical machines, each comprising a permanent magnet rotor and a stator comprising a plurality of electrically isolated polyphase winding sets, wherein the method comprises:

supplying electrical power to each polyphase winding set of plurality of polyphase windings sets of the first electrical machine;
stopping the supply of electrical power to a first polyphase winding set of the first electrical machine;
measuring a first voltage across the first polyphase winding set of the first electrical machine;
supplying electrical power to each polyphase winding set of the plurality of polyphase windings sets of the second electrical machine;
stopping the supply of electrical power to a first polyphase winding set of the second electrical machine;
measuring a second voltage across the first polyphase winding set of the second electrical machine;
determining first and second magnetic flux linkage indicators based on the first and second voltages; and

determining whether the permanent magnet rotor of the first and/or second electrical machine is demagnetized based on the whether a ratio of the first and second magnetic flux linkage indicators passes a threshold.

Optionally, the method comprises: determining whether the permanent magnet rotor of the first electrical machine is demagnetized based on the whether the ratio of the first and second magnetic flux linkage indicators is below a first threshold; and determining whether the permanent magnet rotor of the second electrical machine is demagnetized based on the whether the ratio of the first and second magnetic flux linkage indicators is above a second threshold.

Optionally, supplying electrical power to each polyphase winding set of the plurality of polyphase windings sets of the first electrical machine comprises supplying less than 25% of a rated power of the first electrical machine; and supplying electrical power to each polyphase winding set of the plurality of polyphase windings sets of the first electrical machine comprises supplying less than 25% of a rated power of the first electrical machine.

According to the invention, supplying electrical power to each polyphase winding set of the plurality of polyphase windings sets of the first electrical machine comprises supplying electrical power to only one phase of a plurality of phases of each polyphase winding set of the first electrical machine; and supplying electrical power to each polyphase winding set of the plurality of polyphase windings sets of the second electrical machine comprises supplying electrical power to only one phase of a plurality of phases of each polyphase winding set of the second electrical machine.

Optionally, stopping the supply of electrical power to the first polyphase winding set of the first electrical machine comprises opening a circuit breaker connected with the first polyphase winding set of the first electrical machine is connected.

Optionally, the electrical power system further comprises a plurality of DC:AC power converters, and, for each of the first and second electrical machines, each respective polyphase winding set of the plurality of polyphase winding sets is connected to and configured to receive electrical power from a respective one of the plurality of DC:AC power converters; and stopping the supply of electrical power to the first polyphase winding set of the first electrical machine comprises controlling a switching operation of the DC:AC converter to which the first polyphase winding set of the first electrical machine is connected to block current flow to the first polyphase winding set of the first electrical machine.

The skilled person will appreciate that, except where mutually exclusive, a feature described in relation to any one of the above aspects may be applied mutatis mutandis to any other aspect. Furthermore, except where mutually exclusive, any feature described herein may be applied to any aspect and/or combined with any other feature described herein.

## BRIEF DESCRIPTION OF THE DRAWINGS

Embodiments will now be described by way of example only with reference to the accompanying drawings, which are purely schematic and not to scale, and in which:

**FIG.1** is a perspective view of a VTOL aircraft;
**FIG. 2** is a schematic illustration of a power and propulsion system of an aircraft comprising a gas turbine engine;
**FIG. 3A** illustrates a permanent magnet radial flux electrical machine comprising two electrically isolated polyphase winding sets;
**FIG. 3B** illustrates a permanent magnet transverse flux electrical machine comprising two electrically isolated polyphase winding sets;
**FIG. 4** is a schematic illustration of a portion of an electrical power system, configured to detect rotor demagnetization in its permanent magnet electrical machines;
**FIG. 5** is a schematic illustration of a portion of an electrical power system, in which the permanent magnet electrical machines have four electrically isolated polyphase winding sets; and
**FIG. 6** is a flow chart illustrating a method of operating an electrical power system to detect rotor demagnetization.

## DETAILED DESCRIPTION

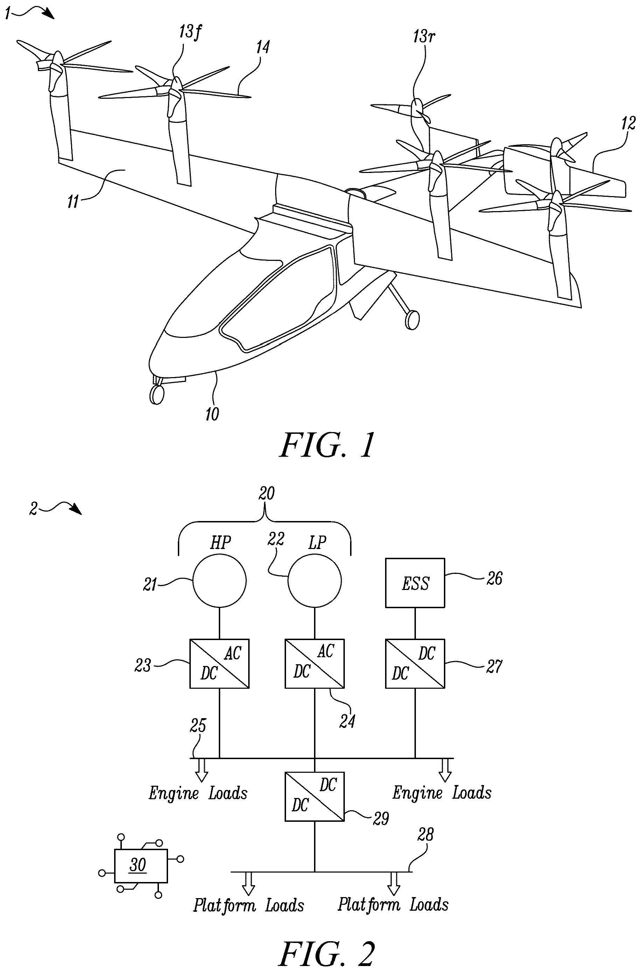

**FIG. 1** illustrates a Vertical Take-Off and Landing (VTOL) aircraft 1. The VTOL aircraft has a fuselage 10, a front flight surface 11, a rear flight surface 12 and a plurality of electrical propulsion units (EPUs). In this example, the VTOL aircraft 1 has six EPUs, including four front EPUs 13f coupled to the front flight surface 11 and two rear EPUs 13r coupled to the rear flight surface 12. Each EPU 10f, 10r includes a propeller 14, which could instead be a fan (e.g., a ducted fan). Some or all of the EPUs 10f, 10r are tiltable between a vertical take-off configuration (illustrated) and a horizontal flight configuration. In this example, the front and rear flight surfaces 11, 12 are tiltable and the EPUs 10f, 10r tilt therewith. In other examples, the EPUs 10f, 10r may instead be tiltable relative to the flight surfaces 11, 12.

The propeller 14 of each EPU 10f, 10r can be driven to rotate by an electrical machine (not visible) incorporated within the EPU. The electrical machines receive power from an on-board power source (also not visible), which in one example is an Energy Storage System (ESS) comprising one or more batteries. In other examples, the VTOL aircraft 1 has a hybrid power system that includes, for example, batteries and fuel cells, or batteries and a turboelectric generator (e.g., a gas turbine engine and electrical machine coupled to a rotating shaft of the gas turbine engine).

**FIG. 2** is a schematic illustration of a power and propulsion system 2 of an aircraft that includes a gas turbine engine 20. In this example the gas turbine engine 20 has two spools, a high-pressure (HP) spool and a low-pressure (LP) spool. The HP spool is mechanically coupled to a first electrical machine 21 and the LP spool is coupled to a second electrical machine 22. The electrical machines 21, 22 interface with a first DC electrical network 25 via DC:AC power converters 23, 24, which in this example are bi-directional DC:AC power converters whereby the electrical machines are operable as generators (for supplying power to the first DC electrical network 25) or motors (for accelerating the LP and/or HP spool, e.g., for engine starting or improving engine operability).

The first DC electrical network 25, which in this example powers electrical loads associated with the gas turbine engine 20 (e.g., electric engine accessories such as motors of fuel or oil pumps), can also exchange power with an ESS 26, optionally via a DC:DC power converter 27. The power and propulsion system further includes a second DC electrical network 28 that powers platform loads (i.e., those associated with the wider aircraft). The voltage of the second electrical network 28 is different than (e.g., less than) the voltage of the first electrical network 25, and a second DC:DC power converter 29 provides an interface between the two DC electrical networks 25, 28.

A control system 30, which may comprise single controller or multiple distributed controllers and various sensors, may control the operating modes of the electrical machines 21, 22 and the switching operation of the power semiconductor switches of the power converters 23, 24, 27, 29. In accordance with the present disclosure, the control system 30 may also perform health monitoring operations to detect rotor demagnetization in the electrical machines 21, 22.

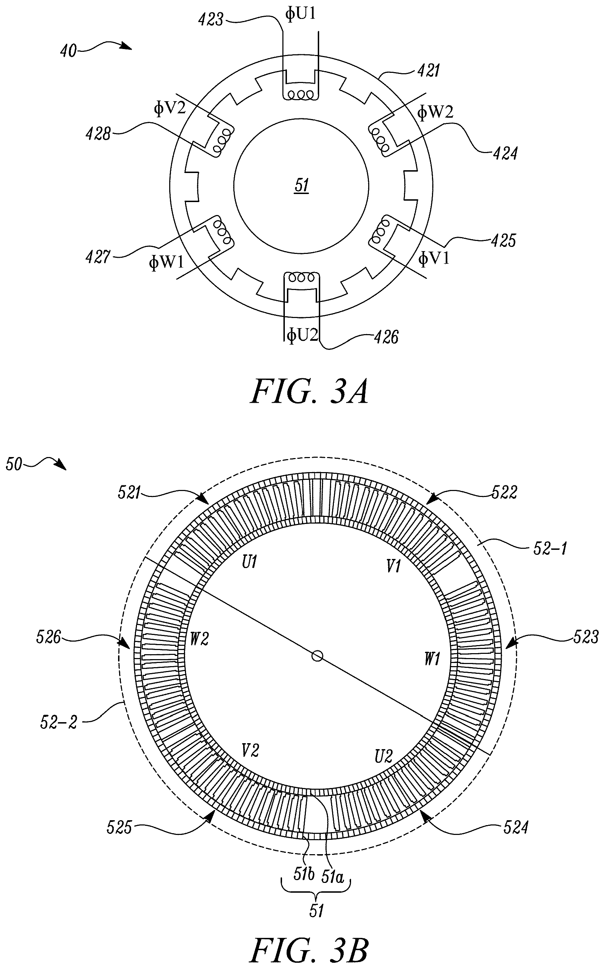

Electrical power systems used in aerospace applications such as those described above may have relatively high fault tolerance requirements. To this end, the electrical machines may be designed to have redundancy. One example of this is the provision of permanent magnet electrical machines that have stators with multiple electrically independent stator winding sets that interact with a common rotor. Non-limiting examples of this are illustrated in FIGS. 3A-3B.

**FIG. 3A** illustrates a permanent magnet radial flux electrical machine 40. The electrical machine 40 has a rotor 41 and a stator 42 that radially surrounds the rotor, though the rotor 41 could instead radially surround the stator 42. A surface of the rotor 41 facing the stator 42 carries permanent magnets (e.g., rare earth magnets) for interaction with the stator 42. The stator 42 has a generally annular back iron 421 and a plurality of teeth 422 that extend radially from the back iron 421 and are evenly distributed about the circumference of the stator 42. The stator 42 further includes two electrically independent three-phase winding sets, the coils of which are wound around the teeth 422. In FIG. 3A the two winding sets are designated "1" and "2", and the three phases are designated "U", "V" and "W". Thus, the first three-phase winding set has phases U1, V1, W1 and these are associated with the coils 423, 425, 427. The second winding set has phases U2, V2, W2 and these are associated with the coils 424, 426, 428.

The coils 423, 425, 427 that form the first winding set are electrically connected, for example in a star or delta configuration. Likewise, the coils 424, 426, 428 that form the second winding set are electrically connected, for example in a star or delta configuration. However, to ensure the first and second winding sets are electrically isolated, the first set of coils 423, 425, 427 are not electrically connected with the second set of coils 424, 426, 428. Thus, if there is an electrical fault (e.g., a phase fault) in one of the winding sets, the fault should not electrically propagate to the other winding set. A fault in one winding set that, e.g., requires disconnection of the winding set from the wider power system does not prevent the motor 40 from operating, and with suitable overrating of the motor 40, it may continue operation at full or close to full rated power.

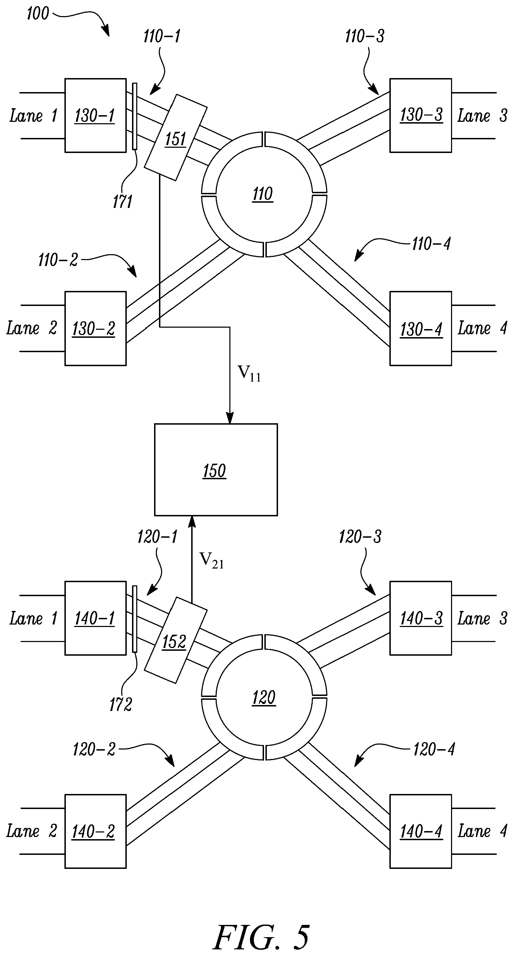

In the present example, the circumferentially adjacent coils (e.g., coils 423, 424) belong to different winding sets. In other examples, including those shown in FIG. 3B and FIG. 5, the circumference of the stator is divided into arcuate sectors, the angular size of each sector being 360°/N where N is the number of winding sets, and each winding set occupies one of the N sectors. In the present example, a concentrated winding scheme is applied, and a coil is wound around every second stator tooth 422 so that an unwound tooth separates circumferentially adjacent coils. This is not essential, but increases the thermal, mechanical and magnetic isolation between the two winding sets and thus further reduces the risk of fault propagation.

**FIG. 3B** illustrates a permanent magnet transverse flux electrical machine 50. The electrical machine 50 has a permanent magnet rotor 51, which in this example comprises first and second rotor portions 51a, 51b. The electrical machine 50 further includes a stator 52 provided between the rotor portions 51a, 51b. Each of the rotor portions 51a, 51b carries an array of permanent magnets (e.g., a Halbach array) on a side of the rotor portion facing the stator 52 for interaction therewith. The stator 52 comprises two three-phase winding sets. As in FIG. 3A, the two winding sets are designated "1" and "2", and the three phases are designated "U", "V" and "W".

In this example, the rotor portions 51a, 51b are radially spaced and the stator 52 is provided radially between the rotor portions 51a, 51b. In other transverse flux electrical machines, the rotor portions 51a, 51b are axially spaced and the stator 52 is provided axially between the rotor portions 51a, 51b. The use of two rotor portions 51a, 51b helps close the magnetic circuits without the requirement for rotor iron (i.e., an ironless rotor can be used), but this is not essential; some transverse flux electrical machines have only a single rotor portion.

Each phase (U, V, W) of each winding set (1, 2) of the stator 52 is associated with a stator segment 521-526, and each stator segment 521-526 comprises a set of flux guiding iron pieces (e.g., comprising a soft magnetic composite) and a coil through which coil flows in a generally circumferential direction. It is noted that FIG. 3B shows the flux guiding iron pieces but omits the coils for clarity. Further examples may be found in US Patent Publication US 11,611,247 B2.

The coils 521, 522, 523 that form the first winding set are electrically connected, for example in a star or delta configuration. Likewise, the coils 524, 525, 526 that form the second winding set are electrically connected, for example in a star or delta configuration. However, to ensure the first and second winding sets are electrically isolated, the first set of coils 521-523 are not electrically connected with the second set of coils 524-526. Thus, if there is an electrical fault (e.g., a phase fault) in one of the winding sets, the fault should not electrically propagate to the other winding set. A fault in one winding set that, e.g., requires disconnection of the winding set does not prevent the motor 50 from operating, and with suitable overrating of the motor 50, it may continue operation at full or close to full power.

The circumference of the stator is divided into sectors 52-1, 52-2, the angular size of each sector being 360°/N where N is the number of winding sets (here N = 2), and each winding set occupies one of the sectors. In other examples, analogous to that shown in FIG. 3A, circumferentially adjacent stator segments (e.g., stator segments 521, 522) are associated with different winding sets.

In each of the examples described above, the stators 42, 52 have two electrically independent winding sets each having three-phases. A different number of phases (e.g., four) could be used instead and the term "polyphase" is used herein to indicate this. Further, a stator could have more than two (e.g., three or four) electrically isolated winding sets. The number of winding sets and phases may be selected according to the desired level of fault tolerance, as well as complexity and space constraints, for example.

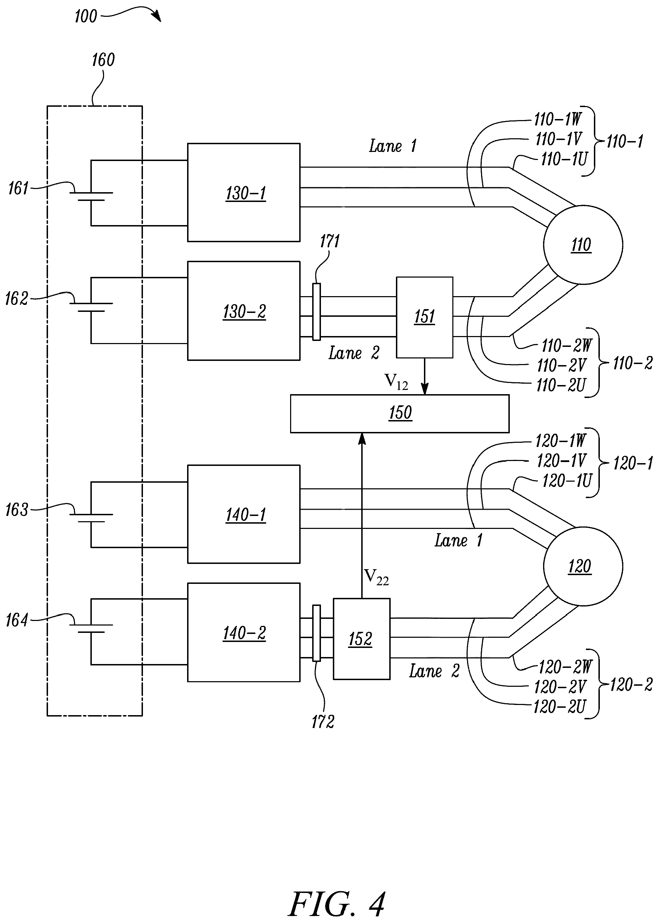

FIG. 4 illustrates an electrical power system 100 that includes two permanent magnet electrical machines 110, 120. The electrical power system 100 could, for example, be a portion of that of the VTOL aircraft 1 of FIG. 1, with the two electrical machines 110, 120 being motors of two propulsors 10f, 10r. The electrical power system 100 could also be that of the FIG. 2, with the two electrical machines 110, 120 being the electrical machines 21, 22 that are coupled to the spools of the gas turbine engine 20. The electrical machines 110, 120 could be permanent magnet radial flux machines, like that described with reference to FIG. 3A. Alternatively, the electrical machines 110, 120 could be permanent magnet transverse flux machines like that described with reference to FIG. 3B, or another type of permanent magnet machine (e.g., axial flux machines).

The first permanent magnet electrical machine 110 has a first winding set 110-1 having three phases 110-1U, 110-1V, 110-1W, and a second winding set 110-2 having three phases 110-2U, 110-2V, 110-2W. The second permanent magnet electrical machine 120 has a first winding set 120-1 having three phases 120-1U, 120-1V, 120-1W, and a second winding set 120-2 having three phases 120-2U, 120-2V, 120-2W. As noted above, a different number of phases may be used.

In the present example, each winding set 110-1, 110-2, 120-1, 120-2 is connected to one of a plurality of DC:AC power converters 130-1, 130-2, 140-1, 140-2. The DC:AC power converters 130-1, 130-2, 140-1, 140-2 may be unidirectional (e.g., the power converters are inverters) or bidirectional. Any suitable converter topology may be used, for example a two-level three-phase full-bridge converter topology, or each DC:AC power converter may comprise three one-phase H-bridge circuits and each phase may be connected to one of the three H-bridges. In still other examples, the DC:AC converters may not be present at all, for example, if the electrical machines 110, 120 are to be supplied without power from an AC power source.

The DC:AC converters 130-1, 130-2, 140-1, 140-2 are connected, at their DC sides, to a DC power source 160, which in this example is an ESS, for example an on-board ESS of an aircraft. In other examples the power source 160 may be a ground-based power source (e.g., airport ground equipment) or an on-board Auxiliary Power Unit (APU).

In the present example, the ESS 160 comprises, for each polyphase winding set 110-1, 110-2, 120-1, 120-2 and associated DC:AC power converter 130-1, 130-2, 140-1, 140-2, an electrically isolated energy storage sub-system 161, 162, 163, 164. The combination of an energy storage sub-system (e.g., 161), the associated DC:AC converter (e.g., 130-1) and the associated polyphase stator winding (e.g., 110-1) may be referred to as a "power lane". Each power lane is electrically isolated from every other power lane, which reduces the likelihood of faults propagating between power lanes and therefore the impact of any single fault.

The electrical power system 100 further includes a control and health monitoring system 150, which is communicatively coupled with voltage sensors 151, 152. The control and health monitoring system 150 is configured to detect the onset of rotor demagnetization in the permanent magnet rotors of the electrical machines 110, 120. To do so, the control and health monitoring system 150 initially supplies power to all the winding sets 110-1, 110-2, 120-1, 120-2 of the two electrical machines 110, 120 to spin up their permanent magnet rotors. The control and health monitoring system 150 then imposes an open circuit condition on one winding set of each electrical machine 110, 120, after which the open circuit winding sets can behave like search coils. Voltages across the open circuit winding sets are measured, and magnetic flux linkage indicators calculated from the measurements. If the two electrical machines 110, 120 are of the same construction and are subject to the measurement conditions during the test, a ratio of the flux linkage indicators will indicate whether there is demagnetization in one of the rotors. For example, a value close to one will indicate there is little or no rotor demagnetization, whereas a value deviating from close to one will indicate one of the rotors has some demagnetization. The rotor demagnetization test is described in more detail below.

First, the control and health monitoring system 150 controls the power system 100 (e.g., controls the switching states of the DC:AC power converters 130-1, 130-2, 140-1, 140-2) to supply electrical power to each of the polyphase winding sets 110-1, 110-2, 120-1, 120-2 of the two electrical machines 110, 120 so that their rotors rotate.

The same voltage and current may be supplied to each machine 110, 120 so that the rotors rotate at the same speed and produce the same torque. For the purposes of the rotor demagnetization test, the electrical machines 110, 120 may not be operated at their full powers, speeds or torques, and thus a relatively low power (e.g., less than 25% of the peak rated powers of the machines 110, 120) may be supplied to the polyphase winding sets 110-1, 110-2, 120-1, 120-2.

According to the invention, power is supplied to just one phase of each winding set (e.g., 110-1U, 110-2V, 120-1U, 120-V).

Next, the control and health monitoring system 150 stops the supply of electrical power to one of the polyphase winding sets of each of the first and second electrical machines 110, 120, e.g., polyphase winding sets 110-2, 120-2. The supply of current to the other polyphase winding sets 110-1, 120-1 continues.

In the illustrated example, the supply of electrical power to the winding sets 110-2, 120-2 is stopped by opening circuit breakers 171, 172 that are connected between the winding sets 110-2, 120-2 and their associated DC:AC converters 130-2, 140-2, disconnecting the winding sets 110-2, 120-2. In another example, the control and health monitoring system 150 controls the switching states of the DC:AC power converters 130-2, 140-2 to block the flow of current to the winding sets 110-2, 120-2. Where circuit brakers 171, 172 are used, they may be mechanical circuit breakers (e.g., AC contactors), solid state circuit breakers (SSCBs) or hybrid breakers.

With the supply of current to the winding sets 110-2, 120-2 stopped but the permanent magnet rotors still rotating, voltages will be induced in the unpowered winding sets 110-2, 120-2. The voltage sensors 151, 152 that are connected across the winding sets 110-2, 120-2 measure the phase voltages across the winding sets and communicate the measurements to the control and health monitoring system 150 for processing.

The voltages $V_{12}$, $V_{22}$ are related to the magnetic flux linkages in the winding sets by the equations:

$$V_{12} = \begin{bmatrix} v_{u12} \\ v_{v12} \\ v_{w12} \end{bmatrix} = \begin{bmatrix} R_{s12} & 0 & 0 \\ 0 & R_{s12} & 0 \\ 0 & 0 & R_{s12} \end{bmatrix} \begin{bmatrix} i_{u12} \\ i_{v12} \\ i_{w12} \end{bmatrix} + \begin{bmatrix} \dfrac{d\Psi_{u12}}{dt} \\ \dfrac{d\Psi_{v12}}{dt} \\ \dfrac{d\Psi_{w12}}{dt} \end{bmatrix} = \begin{bmatrix} \dfrac{d\Psi_{u12}}{dt} \\ \dfrac{d\Psi_{v12}}{dt} \\ \dfrac{d\Psi_{w12}}{dt} \end{bmatrix}$$

$$V_{22} = \begin{bmatrix} v_{u22} \\ v_{v22} \\ v_{w22} \end{bmatrix} = \begin{bmatrix} R_{s22} & 0 & 0 \\ 0 & R_{s22} & 0 \\ 0 & 0 & R_{s22} \end{bmatrix} \begin{bmatrix} i_{u22} \\ i_{v22} \\ i_{w22} \end{bmatrix} + \begin{bmatrix} \dfrac{d\Psi_{u22}}{dt} \\ \dfrac{d\Psi_{v22}}{dt} \\ \dfrac{d\Psi_{w22}}{dt} \end{bmatrix} = \begin{bmatrix} \dfrac{d\Psi_{u22}}{dt} \\ \dfrac{d\Psi_{v22}}{dt} \\ \dfrac{d\Psi_{w22}}{dt} \end{bmatrix}$$

Here, $v_{u12}$ is the phase voltage associated with phase u for the winding set 110-2, $v_{w22}$ is the phase voltage associated with phase w for the winding set 120-2, and so forth - these values are measured by voltage sensors 151, 152. $\Psi_{u12}$ is the magnetic flux linkage of the phase u of the winding set 110-2, $\Psi_{w22}$ is the magnetic flux linkage of the phase w of the winding set 120-2, and so forth. $\dfrac{d\Psi_{u12}}{dt}$ and $\dfrac{d\Psi_{w22}}{dt}$ are their time derivatives. $R_{s12}$ and $R_{s22}$ are the equivalent resistances of the stator winding sets 110-2, 120-2, while the currents, e.g., $i_{u12}$, are the individual phase currents. The winding sets 110-2, 120-2 are in an open circuit state when the voltages are measured, so the phase currents are zero, and so the intermediate term is also zero. Consequently, integrating the measured voltages with respect to time will give flux linkage values.

Thus, after receiving the measurements of the phase voltages, the control and health monitoring system 150 integrates the phase voltage values to give the magnetic flux linkage values. The control and health monitoring system 150 then determines a flux value indicator, $F_1$, $F_2$ from the flux linkage values. For example, the control and health monitoring system 150 may take the absolute values of the flux linkage vectors to give the indicators:

$$F_1 = \sqrt{\Psi_{u12}{}^2 + \Psi_{v12}{}^2 + \Psi_{w12}{}^2}$$

$$F_2 = \sqrt{{\Psi_{u22}}^2 + {\Psi_{v22}}^2 + {\Psi_{w22}}^2}$$

Another flux linkage indicator value could be calculated, provided the same calculation is used for both $F_1$ and $F_2$.

Next, the control and health monitoring system 150 determines a ratio, $F_1/F_2$. If the ratio is approximately equal to one, this indicates that neither of the electrical machines has significant rotor demagnetization. If the ratio is less than one (e.g., less than a first predefined threshold), this indicates the rotor of the first electrical machine has at least some rotor demagnetization. If the ratio is greater than one (e.g., greater than a second predefined threshold), this indicates the rotor of the second electrical machine has at least some rotor demagnetization. In one specific example, the first threshold is 0.9 and the second threshold is 1.1. In another specific example, first threshold is 0.8 and the second threshold is 1.2.

Notably, since the ratio is a dimensionless value and the electrical machines 110, 120 are of the same construction and subject to the same test conditions, thresholds can be defined without recourse to extensive testing or historical operating data. Further, the level of complexity associated with performing the test is relatively low.

**FIG. 5** illustrates an example electrical power system 100 in which each of the electrical machines 110, 120 has four electrically isolated polyphase winding sets. Specifically, the first electrical machine 110 has a first three-phase winding set 110-1, a second three-phase winding set 110-2, a third three-phase winding set 110-3 and a fourth three-phase winding set 110-4. The second electrical machine 120 has a first three-phase winding set 120-1, a second three-phase winding set 120-2, a third three-phase winding set 120-3 and a fourth three-phase winding set 120-4. In this example, the circumferences of the stators are divided into N = 4 sectors, each subtending an angle of 90°, and each polyphase winding set occupies one of the sectors.

As in FIG. 4, each polyphase winding set 110-1, 110-2, 110-3, 110-4, 120-1, 120-2, 120-3, 120-4 is connected to one of a plurality of DC:AC power converters 130-1, 130-2, 130-3, 130-4, 140-1, 140-2, 140-3, 140-4. As before, the DC:AC power converters may be of any suitable topology and may be omitted entirely if an AC power source is used. It is noted that, for clarity, no power sources (e.g., ESS 160) are shown in FIG. 5.

The electrical power system 100 further includes a control and health monitoring system 150, voltage sensors 151, 152 and circuit breakers 171, 172. The control and health monitoring system 150 is configured to detect the onset of rotor demagnetization in the permanent magnet electrical machines 110, 120. The details of the rotor demagnetization test are substantially the same as described above. Initially, power is supplied to each of the winding sets 110-1, 110-2, 110-3, 110-4, 120-1, 120-2, 120-3, 120-4 of the electrical machines. One of the winding sets of each machine, e.g., winding sets 130-1, 140-1, is then placed in an open circuit condition, for example by opening the circuit breakers 171, 172. The voltage sensors 151, 152 then measure the phase voltages across each of the open circuit winding sets 130-1, 140-1. The control and health monitoring system 150 receives the voltage measurements and determines magnetic flux indicators F1, F2 from the voltage measurements. Whether there is rotor demagnetization is determined based on whether a ratio of the flux indicators passes a threshold.

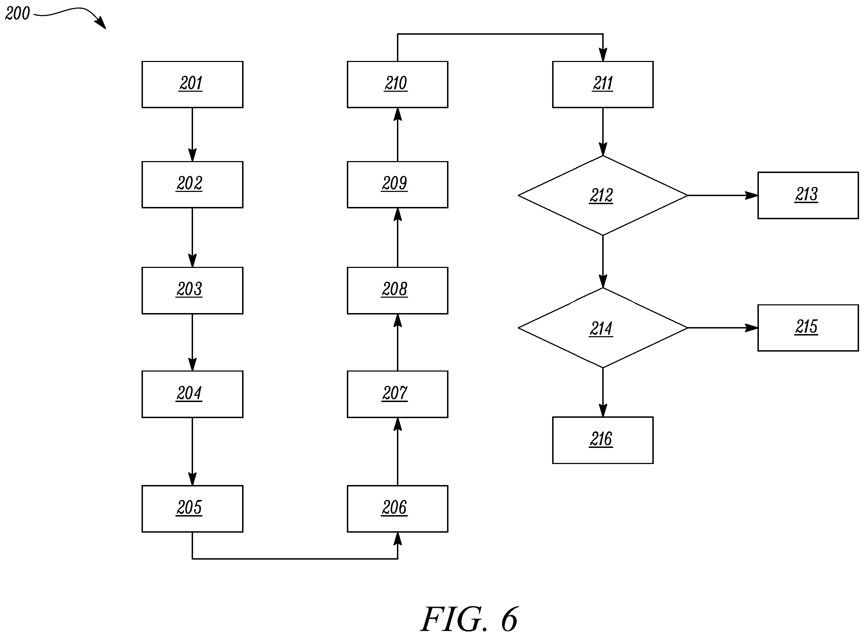

**FIG. 6** is a flow chart illustrating a method 200 of operating an electrical power system 100 to detect rotor demagnetization. The electrical power system 100, which may be of the types shown in FIGS. 4-5, comprises at least two electrical machines, each comprising at least two electrically isolated polyphase winding sets. The method 200 may be performed under the control of a control and health monitoring system 150, which may be pre-programmed to perform a rotor demagnetization test, e.g., during a prestart system check. In an example, the control and health monitoring system 150 may be or comprise a power converter controller.

At 201, the control and health monitoring system 150 initiates the supply of electrical power to all of the winding sets of the first electrical machine 110 (e.g., 110-1, 110-2 in FIG. 4). In an example, the control and health monitoring system 150 controls the DC:AC converters (e.g., 130-1, 130-2) to initiate the supply of current to the windings. According to the invention, power is supplied to one of the phases of each winding set. A low power (e.g., less than 25% of the rated power) sufficient to rotate the rotor may be supplied to electrical machine 110.

At 202, the control and health monitoring system 150 stops the supply of electrical power to one of the winding sets of the first electrical machine (e.g., winding set 110-2 in FIG. 4). In an example, the control and health monitoring system 150 controls the DC:AC converter 130-2 to stop the flow of current therethrough and opens the contactor 171, placing the winding set 110-2 in an open circuit condition.

At 203, the voltage sensor 151 measures the phase voltages across the open circuit winding set 110-2 and communicates the voltages to the control and health monitoring system 150 for processing.

At 204, the control and health monitoring system 150 determined a first magnetic flux linkage indicator, F1, for the first electrical machine 110. In an example, the control and health monitoring system 150 integrates the phase voltage to give magnetic flux linkage values and then calculates F1 as a predefined function (e.g., the absolute value) of the magnetic flux linkage values.

At 205, the control and health monitoring system 150 stops the supply of electrical power to the first electrical machine 110.

At 206, the control and health monitoring system 150 initiates the supply of electrical power to all of the winding sets of the second electrical machine 120 (e.g., 120-1, 120-2 in FIG. 4). In an example, the control and health monitoring system 150 controls the DC:AC converters (e.g., 140-1, 140-2) to initiate the supply of current to the windings. According to the invention, power is supplied to one of the phases of each winding set. A low power (e.g., less than 25% of the rated power) sufficient to rotate the rotor may be supplied to electrical machine 120.

At 207, the control and health monitoring system 150 stops the supply of electrical power to one of the winding sets of the second electrical machine (e.g., winding set 120-2 in FIG. 4). In an example, the control and health monitoring system 150 controls the DC:AC converter 140-2 to stop the flow of current therethrough and opens the contactor 172, placing the winding set 120-2 in an open circuit condition.

At 208, the voltage sensor 152 measures the phase voltages across the open circuit winding set 120-2 and communicates the voltages to the control and health monitoring system 150 for processing.

At 209, the control and health monitoring system 150 determined a second magnetic flux linkage indicator, F2, for the second electrical machine 110. In an example, the control and health monitoring system 150 integrates the phase voltage to give magnetic flux linkage values and then calculates F2 as a predefined function (e.g., the absolute value) of the magnetic flux linkage values.

At 210, the control and health monitoring system 150 stops the supply of electrical power to the first electrical machine 120.

At 211, the control and health monitoring system 150 calculates a ratio, F1/F2, of the first and second flux linkage indicators.

At 212, the control and health monitoring system 150 asks the question of whether the ratio is less than the first predetermined threshold. In an example, the first threshold has a value of between 0.8 and 0.9.

If the ratio is less than the first predetermined threshold, at 213 the control and health monitoring system 150 determines that the first electrical machine 110 is subject to rotor demagnetization. The control and health monitoring system 150 may output an indicator this effect, for example to an aircraft cockpit display.

At 214, the control and health monitoring system 150 asks the question of whether the ratio is greater than a second predetermined threshold. In an example, the second threshold has a value of between 1.1 and 1.2.

If the ratio is less than the first predetermined threshold, at 215 the control and health monitoring system 150 determines that the second electrical machine 120 is subject to rotor demagnetization. The control and health monitoring system 150 may output an indicator this effect, for example to an aircraft cockpit display.

Embodiments of the present disclosure may be associated with one or more of the following advantages:

- The threshold(s) utilized by the control and health monitoring system 100 may be selected without requiring extensive test and/or historical data.
- Rotor demagnetization may be detected without the addition of many, if any, sensors to the electrical power system 100.
- It is not necessary for the sensors to continuously measure the voltage (and current) with a high sampling rate.
- The method may be applied to any type of PMSM, irrespective of the type and winding arrangement selected for the polyphase winding sets.
- The processing complexity is relatively low and may not require a high-end processor to execute complex algorithms.
- Reduced system downtime and increased reliability.

It will be understood that the invention is not limited to the embodiments above-described and various modifications and improvements can be made without departing from the concepts herein. The invention has been described with reference to aerospace applications but could be used in other transport and non-transport applications. The scope of protection is defined in the appended claims.

**Claims**

1.  An electrical power system comprising:

    first and second electrical machines, each comprising a permanent magnet rotor and a stator comprising a plurality of electrically isolated polyphase winding sets; and
    a control and health monitoring system configured to detect rotor demagnetization of the first and/or second electrical machine by:

        supplying electrical power to each polyphase winding set of the plurality of polyphase windings sets of the first electrical machine;

stopping the supply of electrical power to a first polyphase winding set of the first electrical machine;

measuring a first voltage across the first polyphase winding set of the first electrical machine;

supplying electrical power to each polyphase winding set of the plurality of polyphase windings sets of the second electrical machine;

stopping the supply of electrical power to a first polyphase winding set of the second electrical machine;

measuring a second voltage across the first polyphase winding set of the second electrical machine;

determining first and second magnetic flux linkage indicators based on the first and second voltages; and

determining whether the permanent magnet rotor of the first and/or second electrical machine is demagnetized based on the whether a ratio of the first and second magnetic flux linkage indicators passes a threshold;

and **characterised in that** supplying electrical power to each polyphase winding set of the plurality of polyphase windings sets of the first electrical machine comprises supplying electrical power to only one phase of a plurality of phases of each polyphase winding set of the first electrical machine, and supplying electrical power to each polyphase winding set of the plurality of polyphase windings sets of the second electrical machine comprises supplying electrical power to only one phase of a plurality of phases of each polyphase winding set of the second electrical machine.

2. The electrical power system of claim 1, wherein stopping the supply of electrical power to the first polyphase winding set of the first electrical machine comprises opening a circuit breaker connected with the polyphase winding set of the first electrical machine.

3. The electrical power system of claim 1 or claim 2, further comprising a plurality of DC:AC power converters, wherein, for each of the first and second electrical machines, each respective polyphase winding set of the plurality of polyphase winding sets is connected to and configured to receive electrical power from a respective one of the plurality of DC:AC power converters.

4. The electrical power system of any one of the preceding claims, wherein:

supplying electrical power to each polyphase winding set of the plurality of polyphase windings sets of the first electrical machine comprises supplying less than 25% of a peak rated power of the first electrical machine; and

supplying electrical power to each polyphase winding set of the plurality of polyphase windings sets of the second electrical machine comprises supplying less than 25% of a peak rated power of the second electrical machine.

5. The electrical power system of any one of the preceding claims, further comprising an energy storage system, wherein electrical power is supplied to the polyphase winding sets of the first and second electrical machines from the energy storage system.

6. The electrical power system of any one of the preceding claims, wherein the first and second electrical machines have an equal number of polyphase winding sets.

7. The electrical power system of any one of the preceding claims, wherein, for each of the first and second electrical machines, a circumference the stator is divided into a plurality of sectors and each polyphase winding set of the plurality of polyphase winding sets occupies one of the plurality of sectors.

8. The electrical power system of any one of the preceding claims, wherein the first and second electrical machines are transverse flux electrical machines.

9. A method of detecting rotor demagnetization in a permanent magnet electrical machine of an electrical power system, the electrical power system comprising first and second electrical machines, each comprising a permanent magnet rotor and a stator comprising a plurality of electrically isolated polyphase winding sets,

wherein the method comprises:

supplying electrical power to each polyphase winding set of plurality of polyphase windings sets of the first electrical machine;

stopping the supply of electrical power to a first polyphase winding set of the first electrical machine;

measuring a first voltage across the first polyphase winding set of the first electrical machine;

supplying electrical power to each polyphase winding set of the plurality of polyphase windings sets of the second electrical machine;

stopping the supply of electrical power to a first polyphase winding set of the second electrical machine;
measuring a second voltage across the first polyphase winding set of the second electrical machine;
determining first and second magnetic flux linkage indicators based on the first and second voltages; and

determining whether the permanent magnet rotor of the first and/or second electrical machine is demagnetized based on the whether a ratio of the first and second magnetic flux linkage indicators passes a threshold and **characterised in that** supplying electrical power to each polyphase winding set of the plurality of polyphase windings sets of the first electrical machine comprises supplying electrical power to only one phase of a plurality of phases of each polyphase winding set of the first electrical machine; and
supplying electrical power to each polyphase winding set of the plurality of polyphase windings sets of the second electrical machine comprises supplying electrical power to only one phase of a plurality of phases of each polyphase winding set of the second electrical machine.

**10.** The method of claim 9, comprising:

determining whether the permanent magnet rotor of the first electrical machine is demagnetized based on the whether the ratio of the first and second magnetic flux linkage indicators is below a first threshold; and
determining whether the permanent magnet rotor of the second electrical machine is demagnetized based on the whether the ratio of the first and second magnetic flux linkage indicators is above a second threshold.

**11.** The method of claim 9 or claim 10, wherein:

supplying electrical power to each polyphase winding set of the plurality of polyphase windings sets of the first electrical machine comprises supplying less than 25% of a peak rated power of the first electrical machine; and
supplying electrical power to each polyphase winding set of the plurality of polyphase windings sets of the second electrical machine comprises supplying less than 25% of a peak rated power of the second electrical machine.

**12.** The method of any one of claims 9 to 11, wherein stopping the supply of electrical power to the first polyphase winding set of the first electrical machine comprises opening a circuit connected with the first polyphase winding set of the first electrical machine is connected.

**13.** The method of any one of claims 9 to 12, wherein:

the electrical power system further comprises a plurality of DC:AC power converters, and, for each of the first and second electrical machines, each respective polyphase winding set of the plurality of polyphase winding sets is connected to and configured to receive electrical power from a respective one of the plurality of DC:AC power converters; and
stopping the supply of electrical power to the first polyphase winding set of the first electrical machine comprises controlling a switching operation of the DC:AC converter to which the first polyphase winding set of the first electrical machine is connected to block current flow to the first polyphase winding set of the first electrical machine.

**Patentansprüche**

**1.** Elektrisches Energiesystem, umfassend:

eine erste und eine zweite elektrische Maschine, die jeweils einen Permanentmagnetrotor und einen Stator umfassen, der eine Vielzahl von elektrisch isolierten Mehrphasenwicklungssätzen umfasst; und
ein Steuerungs- und Gesundheitsüberwachungssystem, das dazu konfiguriert ist, Rotordemagnetisierung der ersten und/oder der zweiten elektrischen Maschine durch Folgendes zu erkennen:

Zuführen von elektrischer Energie zu jedem Mehrphasenwicklungssatz aus der Vielzahl von Mehrphasenwicklungssätzen der ersten elektrischen Maschine;
Beenden der Zufuhr von elektrischer Energie zu einem ersten Mehrphasenwicklungssatz der ersten elektrischen Maschine;
Messen einer ersten Spannung über dem ersten Mehrphasenwicklungssatz der ersten elektrischen Maschine;

Zuführen von elektrischer Energie zu jedem Mehrphasenwicklungssatz aus der Vielzahl von Mehrphasenwicklungssätzen der zweiten elektrischen Maschine;

Beenden der Zufuhr von elektrischer Energie zu einem ersten Mehrphasenwicklungssatz der zweiten elektrischen Maschine;

Messen einer zweiten Spannung über dem ersten Mehrphasenwicklungssatz der zweiten elektrischen Maschine;

Bestimmen eines ersten und eines zweiten Magnetflussverknüpfungsindikators basierend auf der ersten und der zweiten Spannung; und

Bestimmen, ob der Permanentmagnetrotor der ersten und/oder der zweiten elektrischen Maschine demagnetisiert ist, basierend darauf, ob ein Verhältnis des ersten und des zweiten Magnetflussverknüpfungsindikators einen Schwellenwert überschreitet; und **dadurch gekennzeichnet, dass** das Zuführen von elektrischer Energie zu jedem Mehrphasenwicklungssatz aus der Vielzahl von Mehrphasenwicklungssätzen der ersten elektrischen Maschine Zuführen von elektrischer Energie zu nur einer Phase aus einer Vielzahl von Phasen von jedem Mehrphasenwicklungssatz der ersten elektrischen Maschine umfasst und das Zuführen von elektrischer Energie zu jedem Mehrphasenwicklungssatz aus der Vielzahl von Mehrphasenwicklungssätzen der zweiten elektrischen Maschine Zuführen von elektrischer Energie zu nur einer Phase aus einer Vielzahl von Phasen von jedem Mehrphasenwicklungssatz der zweiten elektrischen Maschine umfasst.

2. Elektrisches Energiesystem nach Anspruch 1, wobei das Beenden der Zufuhr von elektrischer Energie zu dem ersten Mehrphasenwicklungssatz der ersten elektrischen Maschine Öffnen eines Leistungsschalters umfasst, der mit dem Mehrphasenwicklungssatz der ersten elektrischen Maschine verbunden ist.

3. Elektrisches Energiesystem nach Anspruch 1 oder Anspruch 2, ferner umfassend eine Vielzahl von DC:AC-Energiewandlern, wobei für jede von der ersten und der zweiten elektrischen Maschine jeder jeweilige Mehrphasenwicklungssatz aus der Vielzahl von Mehrphasenwicklungssätzen mit einem jeweiligen aus der Vielzahl von DC:AC-Energiewandlern verbunden und dazu konfiguriert ist, elektrische Energie davon zu empfangen.

4. Elektrisches Energiesystem nach einem der vorhergehenden Ansprüche, wobei:

   das Zuführen von elektrischer Energie zu jedem Mehrphasenwicklungssatz aus der Vielzahl von Mehrphasenwicklungssätzen der ersten elektrischen Maschine Zuführen von weniger als 25 % einer Spitzennennleistung der ersten elektrischen Maschine umfasst; und

   das Zuführen von elektrischer Energie zu jedem Mehrphasenwicklungssatz aus der Vielzahl von Mehrphasenwicklungssätzen der zweiten elektrischen Maschine Zuführen von weniger als 25 % einer Spitzennennleistung der zweiten elektrischen Maschine umfasst.

5. Elektrisches Energiesystem nach einem der vorhergehenden Ansprüche, ferner umfassend ein Energiespeichersystem, wobei elektrische Energie den Mehrphasenwicklungssätzen der ersten und der zweiten elektrischen Maschine von dem Energiespeichersystem zugeführt wird.

6. Elektrisches Energiesystem nach einem der vorhergehenden Ansprüche, wobei die erste und die zweite elektrische Maschine eine gleiche Anzahl an Mehrphasenwicklungssätzen aufweisen.

7. Elektrisches Energiesystem nach einem der vorhergehenden Ansprüche, wobei für jede von der ersten und der zweiten elektrischen Maschine ein Umfang des Stators in eine Vielzahl von Sektoren unterteilt ist und jeder Mehrphasenwicklungssatz aus der Vielzahl von Mehrphasenwicklungssätzen einen aus der Vielzahl von Sektoren einnimmt.

8. Elektrisches Energiesystem nach einem der vorhergehenden Ansprüche, wobei die erste und die zweite elektrische Maschine elektrische Transversalflussmaschinen sind.

9. Verfahren zum Erkennen von Rotordemagnetisierung in einer elektrischen Permanentmagnetmaschine eines elektrischen Energiesystems, wobei das elektrische Energiesystem eine erste und eine zweite elektrische Maschine umfasst, die jeweils einen Permanentmagnetrotor und einen Stator umfassen, der eine Vielzahl von elektrisch isolierten Mehrphasenwicklungssätzen umfasst, wobei das Verfahren Folgendes umfasst:

Zuführen von elektrischer Energie zu jedem Mehrphasenwicklungssatz aus der Vielzahl von Mehrphasenwicklungssätzen der ersten elektrischen Maschine;

Beenden der Zufuhr von elektrischer Energie zu einem ersten Mehrphasenwicklungssatz der ersten elektrischen Maschine;

Messen einer ersten Spannung über dem ersten Mehrphasenwicklungssatz der ersten elektrischen Maschine;

Zuführen von elektrischer Energie zu jedem Mehrphasenwicklungssatz aus der Vielzahl von Mehrphasenwicklungssätzen der zweiten elektrischen Maschine;

Beenden der Zufuhr von elektrischer Energie zu einem ersten Mehrphasenwicklungssatz der zweiten elektrischen Maschine;

Messen einer zweiten Spannung über dem ersten Mehrphasenwicklungssatz der zweiten elektrischen Maschine;

Bestimmen eines ersten und eines zweiten Magnetflussverknüpfungsindikators basierend auf der ersten und der zweiten Spannung; und

Bestimmen, ob der Permanentmagnetrotor der ersten und/oder der zweiten elektrischen Maschine demagnetisiert ist, basierend darauf, ob ein Verhältnis des ersten und des zweiten Magnetflussverknüpfungsindikators einen Schwellenwert überschreitet, und **dadurch gekennzeichnet, dass** das Zuführen von elektrischer Energie zu jedem Mehrphasenwicklungssatz aus der Vielzahl von Mehrphasenwicklungssätzen der ersten elektrischen Maschine Zuführen von elektrischer Energie zu nur einer Phase aus einer Vielzahl von Phasen von jedem Mehrphasenwicklungssatz der ersten elektrischen Maschine umfasst; und

das Zuführen von elektrischer Energie zu jedem Mehrphasenwicklungssatz aus der Vielzahl von Mehrphasenwicklungssätzen der zweiten elektrischen Maschine Zuführen von elektrischer Energie zu nur einer Phase aus einer Vielzahl von Phasen von jedem Mehrphasenwicklungssatz der zweiten elektrischen Maschine umfasst.

**10.** Verfahren nach Anspruch 9, umfassend:

Bestimmen, ob der Permanentmagnetrotor der ersten elektrischen Maschine demagnetisiert ist, basierend darauf, ob das Verhältnis des ersten und des zweiten Magnetflussverknüpfungsindikators unter einem ersten Schwellenwert ist; und

Bestimmen, ob der Permanentmagnetrotor der zweiten elektrischen Maschine demagnetisiert ist, basierend darauf, ob das Verhältnis des ersten und des zweiten Magnetflussverknüpfungsindikators über einem zweiten Schwellenwert ist.

**11.** Verfahren nach Anspruch 9 oder Anspruch 10, wobei:

das Zuführen von elektrischer Energie zu jedem Mehrphasenwicklungssatz aus der Vielzahl von Mehrphasenwicklungssätzen der ersten elektrischen Maschine Zuführen von weniger als 25 % einer Spitzennennleistung der ersten elektrischen Maschine umfasst; und

das Zuführen von elektrischer Energie zu jedem Mehrphasenwicklungssatz aus der Vielzahl von Mehrphasenwicklungssätzen der zweiten elektrischen Maschine Zuführen von weniger als 25 % einer Spitzennennleistung der zweiten elektrischen Maschine umfasst.

**12.** Verfahren nach einem der Ansprüche 9 bis 11, wobei das Beenden der Zufuhr von elektrischer Energie zu dem ersten Mehrphasenwicklungssatz der ersten elektrischen Maschine Öffnen einer Schaltung umfasst, die mit dem ersten Mehrphasenwicklungssatz der ersten elektrischen Maschine verbunden ist, verbunden ist.

**13.** Verfahren nach einem der Ansprüche 9 bis 12, wobei:

das elektrische Energiesystem ferner eine Vielzahl von DC:AC-Energiewandlern umfasst und für jede von der ersten und der zweiten elektrischen Maschine jeder jeweilige Mehrphasenwicklungssatz aus der Vielzahl von Mehrphasenwicklungssätzen mit einem jeweiligen aus der Vielzahl von DC:AC-Energiewandlern verbunden und dazu konfiguriert ist, elektrische Energie davon zu empfangen; und

das Beenden der Zufuhr von elektrischer Energie zu dem ersten Mehrphasenwicklungssatz der ersten elektrischen Maschine Steuern eines Schaltvorgangs des DC:AC-Wandlers, mit dem der erste Mehrphasenwicklungssatz der ersten elektrischen Maschine verbunden ist, um Stromfluss zu dem ersten Mehrphasenwicklungssatz der ersten elektrischen Maschine zu blockieren, umfasst.

**Revendications**

1. Système d'énergie électrique comprenant :

des première et seconde machines électriques, comprenant chacune un rotor à aimant permanent et un stator comprenant une pluralité d'ensembles d'enroulements polyphasés électriquement isolés ; et
un système de commande et de surveillance d'état de santé conçu pour détecter la démagnétisation de rotor de la première et/ou de la seconde machine électrique par :

la fourniture d'énergie électrique à chaque ensemble d'enroulements polyphasés de la pluralité d'ensembles d'enroulements polyphasés de la première machine électrique ;
l'arrêt de la fourniture d'énergie électrique à un premier ensemble d'enroulements polyphasés de la première machine électrique ;
la mesure d'une première tension aux bornes du premier ensemble d'enroulements polyphasés de la première machine électrique ;
la fourniture d'énergie électrique à chaque ensemble d'enroulements polyphasés de la pluralité d'ensembles d'enroulements polyphasés de la seconde machine électrique ;
l'arrêt de la fourniture d'énergie électrique à un premier ensemble d'enroulements polyphasés de la seconde machine électrique ;
la mesure d'une seconde tension aux bornes du premier ensemble d'enroulements polyphasés de la seconde machine électrique ;
la détermination des premier et second indicateurs de couplage de flux magnétique sur la base des première et seconde tensions ; et
la détermination pour savoir si le rotor à aimant permanent de la première et/ou de la seconde machine électrique est démagnétisé sur la base qu'un rapport des premier et second indicateurs de couplage de flux magnétique dépasse un seuil ; et **caractérisé en ce que** la fourniture d'énergie électrique à chaque ensemble d'enroulements polyphasés de la pluralité d'ensembles d'enroulements polyphasés de la première machine électrique comprend la fourniture d'énergie électrique à une seule phase d'une pluralité de phases de chaque ensemble d'enroulements polyphasés de la première machine électrique, et la fourniture d'énergie électrique à chaque ensemble d'enroulements polyphasés de la pluralité d'ensembles d'enroulements polyphasés de la seconde machine électrique comprend la fourniture d'énergie électrique à une seule phase d'une pluralité de phases de chaque ensemble d'enroulements polyphasés de la seconde machine électrique.

2. Système d'énergie électrique de la revendication 1, ledit arrêt de la fourniture d'énergie électrique au premier ensemble d'enroulements polyphasés de la première machine électrique comprenant l'ouverture d'un disjoncteur connecté à l'ensemble d'enroulements polyphasés de la première machine électrique.

3. Système d'énergie électrique de la revendication 1 ou de la revendication 2, comprenant en outre une pluralité de convertisseurs d'énergie CC-CA, pour chacune des première et seconde machines électriques, chaque ensemble d'enroulements polyphasés respectif de la pluralité d'ensembles d'enroulements polyphasés étant connecté à un convertisseur respectif de la pluralité de convertisseurs d'énergie CC-CA et configuré pour recevoir de l'énergie électrique en provenance de celui-ci.

4. Système d'énergie électrique de l'une quelconque des revendications précédentes :

ladite fourniture d'énergie électrique à chaque ensemble d'enroulements polyphasés de la pluralité d'ensembles d'enroulements polyphasés de la première machine électrique comprenant la fourniture de moins de 25 % d'une puissance nominale de crête de la première machine électrique ; et
ladite fourniture d'énergie électrique à chaque ensemble d'enroulements polyphasés de la pluralité d'ensembles d'enroulements polyphasés de la seconde machine électrique comprenant la fourniture de moins de 25 % d'une puissance nominale de crête de la seconde machine électrique.

5. Système d'énergie électrique de l'une quelconque des revendications précédentes, comprenant en outre un système de stockage d'énergie, ladite énergie électrique étant fournie aux ensembles d'enroulements polyphasés des première et seconde machines électriques à partir du système de stockage d'énergie.

6. Système d'énergie électrique de l'une quelconque des revendications précédentes, lesdites première et seconde machines électriques possédant un nombre égal d'ensembles d'enroulements polyphasés.

7. Système d'énergie électrique de l'une quelconque des revendications précédentes, pour chacune des première et seconde machines électriques, une circonférence du stator étant divisée en une pluralité de secteurs et chaque ensemble d'enroulements polyphasés de la pluralité d'ensembles d'enroulements polyphasés occupant l'un de la pluralité de secteurs.

8. Système d'énergie électrique de l'une quelconque des revendications précédentes, lesdites première et seconde machines électriques étant des machines électriques à flux transversal.

9. Procédé de détection de la démagnétisation de rotor dans une machine électrique à aimant permanent d'un système d'énergie électrique, le système d'énergie électrique comprenant des première et seconde machines électriques, comprenant chacune un rotor à aimant permanent et un stator comprenant une pluralité d'ensembles d'enroulements polyphasés électriquement isolés,
ledit procédé comprenant :

la fourniture d'énergie électrique à chaque ensemble d'enroulements polyphasés d'une pluralité d'ensembles d'enroulements polyphasés de la première machine électrique ;
l'arrêt de la fourniture d'énergie électrique à un premier ensemble d'enroulements polyphasés de la première machine électrique ;
la mesure d'une première tension aux bornes du premier ensemble d'enroulements polyphasés de la première machine électrique ;
la fourniture d'énergie électrique à chaque ensemble d'enroulements polyphasés de la pluralité d'ensembles d'enroulements polyphasés de la seconde machine électrique ;
l'arrêt de la fourniture d'énergie électrique à un premier ensemble d'enroulements polyphasés de la seconde machine électrique ;
la mesure d'une seconde tension aux bornes du premier ensemble d'enroulements polyphasés de la seconde machine électrique ;
la détermination des premier et second indicateurs de couplage de flux magnétique sur la base des première et seconde tensions ; et
la détermination pour savoir si le rotor à aimant permanent de la première et/ou de la seconde machine électrique est démagnétisé sur la base qu'un rapport des premier et second indicateurs de couplage de flux magnétique dépasse ou non un seuil et **caractérisé en ce que** la fourniture d'énergie électrique à chaque ensemble d'enroulements polyphasés de la pluralité d'ensembles d'enroulements polyphasés de la première machine électrique comprend la fourniture d'énergie électrique à une seule phase d'une pluralité de phases de chaque ensemble d'enroulements polyphasés de la première machine électrique ; et
la fourniture d'énergie électrique à chaque ensemble d'enroulements polyphasés de la pluralité d'ensembles d'enroulements polyphasés de la seconde machine électrique comprenant la fourniture d'énergie électrique à une seule phase d'une pluralité de phases de chaque ensemble d'enroulements polyphasés de la seconde machine électrique.

10. Procédé de la revendication 9, comprenant :

la détermination pour savoir si le rotor à aimant permanent de la première machine électrique est démagnétisé sur la base que le rapport des premier et second indicateurs de couplage de flux magnétique est ou non inférieur à un premier seuil ; et
la détermination pour savoir si le rotor à aimant permanent de la seconde machine électrique est démagnétisé sur la base que le rapport des premier et second indicateurs de couplage de flux magnétique est ou non inférieur à un second seuil.

11. Procédé de la revendication 9 ou de la revendication 10 :

ladite fourniture d'énergie électrique à chaque ensemble d'enroulements polyphasés de la pluralité d'ensembles d'enroulements polyphasés de la première machine électrique comprenant la fourniture de moins de 25 % d'une puissance nominale de crête de la première machine électrique ; et
ladite fourniture d'énergie électrique à chaque ensemble d'enroulements polyphasés de la pluralité d'ensembles d'enroulements polyphasés de la seconde machine électrique comprenant la fourniture de moins de 25 % d'une puissance nominale de crête de la seconde machine électrique.

**12.** Procédé de l'une quelconque des revendications 9 à 11, ledit arrêt de la fourniture d'énergie électrique au premier ensemble d'enroulements polyphasés de la première machine électrique comprenant l'ouverture d'un circuit connecté au premier ensemble d'enroulements polyphasés de la première machine électrique est connecté.

**13.** Procédé de l'une quelconque des revendications 9 à 12 :

ledit système d'énergie électrique comprenant en outre une pluralité de convertisseurs d'énergie CC-CA, et, pour chacune des première et seconde machines électriques, chaque ensemble d'enroulements polyphasés respectif de la pluralité d'ensembles d'enroulements polyphasés étant connecté à un convertisseur respectif de la pluralité de convertisseurs d'énergie CC-CA et configuré pour recevoir de l'énergie électrique en provenance de celui-ci ; et

ledit arrêt de la fourniture d'énergie électrique au premier ensemble d'enroulements polyphasés de la première machine électrique comprenant la commande d'une opération de commutation du convertisseur CC-CA auquel le premier ensemble d'enroulements polyphasés de la première machine électrique est connecté pour bloquer la circulation de courant vers le premier ensemble d'enroulements polyphasés de la première machine électrique.

**FIG. 1**

**FIG. 2**

## FIG. 3A

## FIG. 3B

**FIG. 4**

*FIG. 5*

FIG. 6

EP 4 614 803 B1

**EP 4 614 803 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3876419 B1
- US 2022282635 A1
- US 2012146683 A1
- US 11611247 B2